(19) Europäisches Patentamt
European Patent Office
Office européen des brevets

(11) **EP 0 862 992 A1**

(12) **EUROPEAN PATENT APPLICATION**
published in accordance with Art. 158(3) EPC

(43) Date of publication:
09.09.1998 Bulletin 1998/37

(51) Int. Cl.[6]: **B32B 7/06**, B32B 27/00,
C09J 7/02

(21) Application number: 96927210.3

(22) Date of filing: 20.08.1996

(86) International application number:
PCT/JP96/02329

(87) International publication number:
WO 97/06947 (27.02.1997 Gazette 1997/10)

(84) Designated Contracting States:
DE FR GB

(30) Priority: 21.08.1995 JP 211651/95

(71) Applicant:
NITTO DENKO CORPORATION
Osaka (JP)

(72) Inventors:
• ARAKAWA, Masaaki
Ibaraki-shi Osaka 567 (JP)

• SUZUKI, Kihachi
Ibaraki-shi Osaka 567 (JP)
• GOTO, Kazuhito
Ibaraki-shi Osaka 567 (JP)

(74) Representative:
Grünecker, Kinkeldey,
Stockmair & Schwanhäusser
Anwaltssozietät
Maximilianstrasse 58
80538 München (DE)

(54) **PACKING MATERIAL, BASE MATERIAL FOR ADHESIVE TAPE, OR SEPARATOR**

(57) The present invention relates to a packaging material, base material for pressure-sensitive adhesive tape or separator, wherein a releasing agent layer, which can be discontinued so that a part of the support can be exposed, is formed on at least one surface of a film support. Further, the present invention relates to a packaging material, base material for pressure-sensitive adhesive tape or separator, wherein a releasing agent layer provided on at least one surface of a film support has cracks, through which the film support surface, i.e., the substrate, is exposed. Still further, the present invention relates to a structure of a sealing part of the above described packaging material etc. formed by heat seal processing of surfaces facing each other of releasing agent layers having cracks.

*FIG. 2*

EP 0 862 992 A1

## Description

### Technical Field

The present invention relates to packaging materials which can be used for packaging sanitary articles such as a sanitary napkin and a disposable diaper, particularly, as a packaging material useful for a package for a sanitary napkin. Further, they are suitably used as base materials for pressure-sensitive adhesive tapes for medical use and surface protection, and as separators for pressure-sensitive adhesive articles such as a pressure-sensitive adhesive sheet, a tape (double sides) and a tack and for disposable articles such as a paper diaper and a napkin.

### Background

Conventionally, as a separator for protecting a pressure-sensitive adhesive layer of a disposable product such as a sanitary napkin and a disposable diaper and also as a packaging material for a sanitary product such as a sanitary napkin, a peel tape or packaging material comprising a support composed of flexible plastic film having a releasing agent layer provided thereon has been proposed.

However, when a packaging material having a conventional releasing function is used for directly packaging a sanitary napkin which has a pressure-sensitive adhesive layer provided thereon to fix the sanitary napkin on an underwear preventing the same from shifting, and a press system or a heat seal system is utilized to seal the packaging material, sealing processing (adhesion processing) is impossible in the case where the surfaces to be adhered with one another are those to which a releasing agent is coated (the surface of a releasing agent layer).

Further, in order to enable the adhesion of a packaging material having a releasing function in the press system or the heat seal system, has been also proposed a packaging material in which a releasing agent is coated only on the part which contacts the pressure-sensitive adhesive layer of a sanitary napkin and the releasing agent is not coated on a part to be sealed. However, in view of complicated production process and yield, a problem of a high cost may arise.

### Disclosure of the Invention

The present inventors have effected extensive study and research efforts in order to solve the above-described problems, and found that an extremely practical packaging material which can be seal-processed according to a press system or a heat seal system even in the case where surfaces of sealing releasing agent layer are to be adhered to each other, i.e., which can overcome the-above-described problem, can be obtained by providing a releasing agent layer on the surface of a film support, which can be discontinued so as to expose a part of the support, thereby achieving the present invention.

The preset invention relates to a packaging material, base material for pressure-sensitive adhesive tape or separator, characterized in that a releasing agent layer, which can be discontinued so as to expose a part of the support, is formed on at least one surface of a film support.

Further, the present invention relates to a packaging material, base material for pressure-sensitive adhesive tape or separator, characterized in that a releasing agent layer provided on at least one surface of a film support has cracks, through which the support surface, i.e., the substrate, is exposed.

Still further, the present invention relates to a structure of a sealing part formed by heat sealing surfaces facing each other of the releasing agent layers having cracks of the above described packaging material etc.

### Brief Explanation of the Drawings

Fig. 1 shows a sectional view of a practical example of a packaging material etc. according to the present invention.

Fig. 2 shows a sectional view of a practical example of a packaging material etc. according to the present invention.

Fig. 3 shows a schematic view in the case where the packaging material according to the present invention is used for packaging a napkin.

Fig. 4 shows an enlarged plane view showing the shape of the releasing agent layer, which has been discontinued by a stretching treatment, of the packaging material etc. according to the present invention.

Fig. 5 shows a schematic view of a sample for measuring sealing strength of a packaging material etc. according to the present invention.

### Most Preferable Embodiments for Effecting the Present Invention

The present invention will be explained below by referring to the attached drawings.

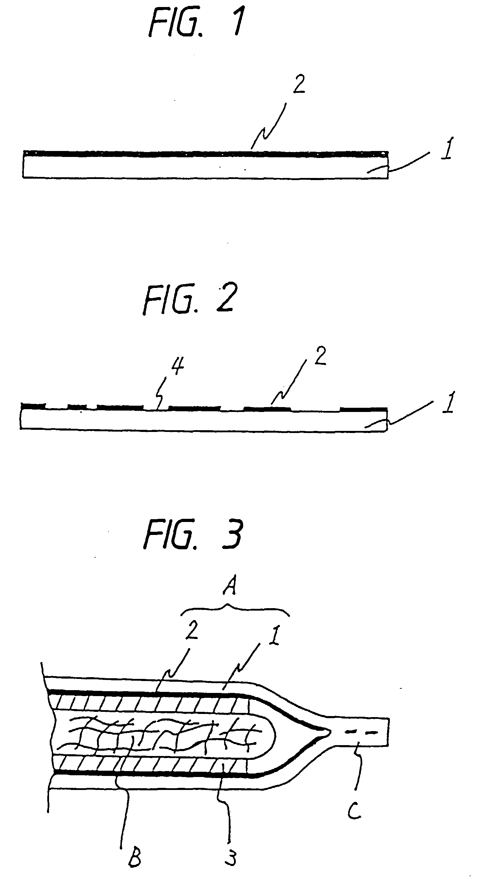

Fig. 1 shows a sectional view showing a practical example of a packaging material according to the present invention, wherein a releasing agent layer 2 which can be discontinued so as to expose a part of the support is formed on one surface of a thermoplastic film support 1.

In accordance with the present invention, the meaning of the description wherein a releasing agent layer formed on at least one surface of a film support can be discontinued so as to expose a part of the support is as follows.

Namely, a releasing agent is coated on a film support, then, a curing or drying treatment is effected to thereby form a releasing agent layer, successively, a below-described discontinuing treatment of the releasing agent layer is effected to cause fine cracks in arbitrary parts of the releasing agent layer, through which the support, i.e., substrate, is exposed. Accordingly, the above-description in the present invention does not mean a known technique wherein a releasing agent is previously coated on a part of a support surface (only a part contacting a pressure-sensitive adhesive layer) so that a support surface is exposed through a releasing agent-uncoated part.

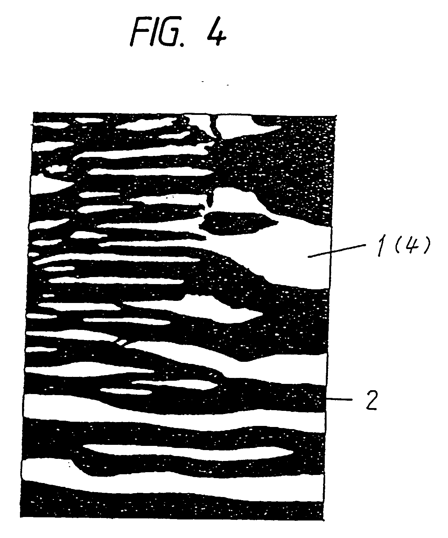

Fig. 2 shows an enlarged sectional view of a packaging material etc. of the present invention wherein the releasing agent layer has been subjected to a discontinuing treatment. It can be seen that cracks are formed in the releasing agent layer 2 and the support 1 substrate is exposed through such cracked parts 4. Fig. 4 shows an enlarged plane view showing the state of the releasing agent layer surface having been subjected to a discontinuing treatment, observed by a scanning electronic microscope (2000 magnifications). It can be also seen from Fig. 4 that cracks are formed in the releasing agent layer 2 by a stretching treatment and the support 1 substrate) is exposed through the cracked parts 4.

In the packaging material etc. of the present invention, for example, in the case where surfaces facing each other of releasing agent layers are seal-processed, a discontinuing treatment is effected in the portion of the releasing agent layers to be seal-processed so that the support is exposed through the cracked parts in the releasing agent layers, and seal-processing is effected by utilizing the exposed parts. In this case, for example, if the support is a plastic film mainly comprising a thermoplastic resin, a seal-processing utilizing heat fusion bonding such as heat seal can be effected.

Fig. 3 shows, in the case where the packaging material of the present invention is used as a package for a sanitary napkin, a sectional view of the sealed portion where surfaces facing each other of releasing agent layers are seal-processed. As shown in the figure, a packaging material A for a napkin B is subjected to a discontinuing treatment only in the releasing agent layer 2 on the sealing portion C and a heat-seal treatment is applied thereto by utilizing the support 1 exposed through the cracked parts in the releasing agent layer 2.

The structure in the sealed part according to the present invention comprises the constitution formed by putting surfaces of releasing agent layers having cracked parts together, then heat fusing-bonding the support exposed through cracked parts in the releasing agent layers by means of heat sealing. Further, the structure in the sealed part in the present invention may be the constitution formed by the combination of a packaging material etc. having cracked parts in a releasing agent layer with a sheet having no releasing agent layer provided thereon and being capable of being fusion-bonded.

Further, in the packaging material according to the present invention, a releasing agent layer can be subjected to a discontinuing treatment not only in a portion to be seal-processed, but also in the entire releasing agent layer. Even in the case of forming cracks entirely, since cracked parts occupy only a small area, without noticeably decreasing releasing property required in a packaging material, both releasing property and sealing property are available at the same time.

The releasing agent of forming a releasing agent layer to be used for the packaging material etc. of the present invention is not particularly limited as long as it has the above-described function. For example, silicone type releasing agents such as thermosetting type, ultraviolet-setting type and electron rays-setting type releasing agents, and long-chain alkyl releasing agents can be arbitrarily selected for use. In particular, if the support is composed of a thermoplastic film, it is preferable to use a silicone type releasing agent such as an ultraviolet-setting type releasing agent or an electron rays-setting type releasing agent, which does not require a thermal treatment in forming a releasing agent film.

The releasing agent which is used for the packaging material etc. of the present invention preferably has specified physical properties of film strength so as to readily form cracks in a releasing agent layer when the releasing agent layer is subjected to a discontinuing treatment. Specifically, the releasing agent film preferably has a breaking strength of 3.0 $kg/cm^2$ to 30 $kg/cm^2$, more preferably 6.0 $kg/cm^2$ to 20 $kg/cm^2$ and/or a Young's modulus of 2.2 $kg/cm^2$ to 500 $kg/cm^2$, more preferably 3.0 $kg/cm^2$ to 300 $kg/cm^2$, which are determined according to the method which will be described below.

If the strength of the releasing agent film is smaller than the range of the above-described physical properties, when the releasing agent layer is subjected to a discontinuing treatment subsequent to the formation of the film, hardness (brittleness) required for the releasing agent layer may become insufficient. As a result, sometimes it can be difficult to expose a support layer by discontinuing the releasing agent layer. While, if it is larger than that range, the releasing agent layer is so brittle that it is readily liable to be slipped off from the support.

The thickness of the releasing agent layer formed on the support surface is not particularly limited as long as releasing function can be kept when the releasing agent layer is subjected to a discontinuing treatment. However, in general, the thickness is preferably from 0.05 to 4.0 $\mu$m, more preferably from 0.3 to 1.5 $\mu$m. The releasing agent layer can be provided on one surface or both surfaces of the support.

The packaging material etc. of the present invention requires a process for discontinuing a releasing agent layer subsequent to forming the releasing agent layer on a support surface so as to partially expose the support. The discontinuing treatment can be applied, depending upon the necessity, to the entire surface of the releasing agent layer or only to the portion of the releasing agent layer to be subjected to seal-adhering. As the discontinuing treatment process of the releasing agent layer, for example, in the case where the support can be stretched, there is a method comprising stretching the support subsequent to the formation of the releasing agent layer on the support so that the entire surface or a part of the surface of the releasing agent layer may be discontinuous.

The stretching method is not particularly limited. Namely, can be utilized various means capable of stretching a support such as stretching between rolls and stretching by a tenter.

The draw ratio in such stretching is preferably 1.1 times or more, more preferably 1.2 to 8 times in TD and/or MD direction of the support. When the draw ratio is less than 1.1 times, the effect for making a releasing agent layer discontinuous is small and, therefore, the exposed area of the support layer is small sometimes to result in insufficient sealabilty.

As other method for making a releasing agent layer discontinuous, can be employed a method comprising forming the releasing agent layer on a surface of a support and then providing permeable pores by sticking the surface of the releasing agent layer with a needle-like projection. Thereby, the cross section of the support layer in the direction of the thickness is exposed with heat and pressure in heat sealing to enable sealing.

As a still other method, mention may be made of a method comprising rubbing the releasing agent layer with other substance to scratch off the releasing agent layer, for example, according to sandblast method to thereby make the releasing agent layer discontinuous.

The packaging material etc. of the present invention desirably has a releasing force-increasing property of 1.1 times or more, preferably 1.2 to 10.0 times after the discontinuing treatment of the releasing agent layer as compared with the releasing force before the discontinuing treatment. If the releasing force-increasing property after the discontinuing treatment of the releasing agent layer is less than 1.1 times, there are some cases where sufficient sealing strength cannot be obtained when surfaces facing each other of the releasing agent layers of the packaging material etc. of the present invention are subjected to sealing processing according to a heat-sealing system.

This releasing force-increasing property can be arbitrarily controlled by changing the draw ratio in the case where stretching is effected as the discontinuing treatment to the releasing agent layer, by changing the number of permeable pores (density) in the case where permeable pores are provided as the discontinuing treatment, or by changing a kind of an abrasion agent or changing conditions such as pressure of spraying an abrasion agent in the case where sandblast method is effected as the discontinuing treatment. Accordingly, depending upon a kind of a discontinuing treatment, the respective treatment conditions are determined so that the releasing force-increasing property falls within the above-described preferable range.

The releasing force-increasing property defined in the present invention means the value determined according to the measurement method described below.

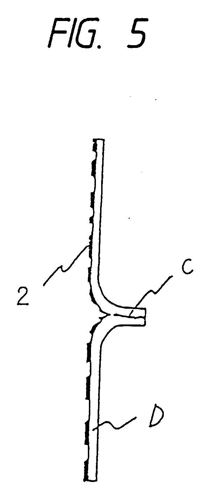

Fig. 5 represents a schematic view of a sample for measuring the sealing strength of the packaging material etc. of the present invention, wherein two sheets of sample pieces D each having a releasing agent layer 2 having been subjected to a discontinuing treatment are put together in such a state that surfaces of the releasing agent layers face each other, and one end of thereof (part C) is subjected to sealing processing.

The packaging material etc. of the present invention has a sealing strength of 2 g/25 mm to the breaking strength of the support (upper limit) showing an adhesion in the sealed part at the time when surfaces facing each other of releasing agent layers are adhered by means of heat seal or press seal, preferably from 5 g/25 mm to 1000 g/25 mm. The breaking strength of the support as used herein means the strength in the case where in measuring sealing strength, peeling does not occur in the sealed portion and the support is broken. That is, it means the state wherein the adhesion strength in the sealed part is extremely high. When the sealing strength is smaller than 2 g/25 mm, the sealed portion may become to be readily peeled off. Therefore, if such a packaging material is used for packaging, maintenance of sealability of the content is liable to be worsened.

The support of a packaging material, a base material for pressure-sensitive adhesive tape or a separator of the present invention is not particularly limited as long as it can be adhered according to press system or heat seal system. For example, preferably, they comprise plastic film mainly comprising a polyolefin type thermoplastic resin.

As such polyolefin type thermoplastic resin, for example, mention may be made of polyethylene, polybutene, polyhexene and polyoctene. They can be used alone or in a mixture thereof. Particularly, polyethylene is preferably used. As such polyethylene, mention may be made of ultra low density polyethylene, low density polyethylene, linear low density polyethylene, medium density polyethylene and high density polyethylene. They can be used alone or in a mixture thereof. As the above-described thermoplastic resin, those comprising 15 % by weight or more of linear low density polyethylene and/or low density polyethylene or those comprising 80 % by weight or less of high density polyethylene are especially preferable. While, if necessary, a material having a higher melting point than ultra low density polyethylene and low density polyethylene may be added to the thermoplastic resin to improve the heat resistance thereof. As such a material, mention can be made of those having a melting point of 185°C or less, preferably 110°C to 180°C.

While, for example, styrene type-, polyolefin type- and polyester type-elastomer components may be added to the thermoplastic resin in an amount of preferably 40 % by weight or less to improve flexibility thereof.

The specific examples of the polymer constituting the thermoplastic film used herein include one selected from ultra low density polyethylene, low density polyethylene, linear low density polyethylene, medium density polyethylene and high density polyethylene, polypropylene, ethylene-vinyl acetate copolymer, ethylene-(meth)acrylic acid copolymer, ethylene-methyl(meth)acrylate copolymer, ethylene-ethyl(meth)acrylate copolymer, polyethylene-propylene copolymer, olefin type elastomer, styrene type elastomer, polyisobutyrene and butyl rubber, or a composite resin composed of two or more kinds thereof.

As the olefin type elastomer, ethylene-propylene rubber (EPT), ethylene-propylene-diene rubber (EPDM), ethylene-propylene type elastomer and ethylene-butene type elastomer can be exemplified. As the styrene type elastomer, styrene-isoprene-styrene block copolymer SIS), styrene-butadiene-styrene block copolymer SBS), or the hydrogenated products thereof can be exemplified.

In the present invention, the support can have mono-layer structure as described above. However, for example, the support composed of at least two layers, wherein one layer having one or two heat-seal layer(s) having a melting point lower than that of the layer by 5°C or more provided on one side or both sides thereof is preferable in heat-sealing conveniently and surely, and is particularly suitable when the present material is used to make a bag or when it is fixed.

Namely, when heated intensively in heat-sealing, there is a fear that the support having a monolayer structure can be broken to form a hole in the sheet, and therefore, the control in heat-sealing is difficult. However, the support comprising two or more layers has a heat seal layer used solely for heat-sealing and, therefore, is effective in determining heat seal conditions with ease.

As such support, can be mentioned a support consisting of two or more layers, i.e., a layer comprising low density polyethylene (melting point 100°C) as a heat seal layer and a layer comprising high density polyethylene etc. (melting point 120°C). In this case, a releasing agent layer is provided on the low density polyethylene side which is a heat seal layer.

Further, as the support of the present invention, a laminated product comprising thermoplastic film and unwoven fabric or woven fabric is also preferable.

In the present invention, by blending the above-described polymers, the surface of the support can be roughened like satin surface or embossed surface so that gloss in the appearance can be lost to provide a feeling of high quality. Further, an effect wherein the coefficient of friction becomes small to improve movabilty in a line can be obtained. In the case of blending polymers having poor compatibility with each other, it is considered that they are mixed at a state where one separates another due the difference in the surface tension at a dissolved state, so that uniform mixing cannot be achieved on the surface portion, namely, the surface is not smooth (roughened), thereby forming a satin or embossing one. The roughness of this surface is usually 0.2 to 30 $\mu$m, preferably 2 to 5 $\mu$m. However, in the case where emboss or satin is formed by the below-described roll, etc., the roughness is preferably not more than 1/2 of the thickness of the film. Further, by blending polymers having different properties, a blend solely having advantages of respective polymers can be formed. Thus, an effect capable of getting a polymer having new functions, for example, simultaneously having flexibility and nerve, can be obtained. Still further, by blending a relatively soft polymer or elastomer as described above, sound produced in peeling for use can be made small and, therefore, an effect wherein the use of the article is not noticed by anyone can be obtained.

In addition to the above-described polymer blending method, a further positive method for forming a satin surface or embossed surface is that, for example, the satin surface or embossed surface can be formed with the face of a roll to be contacted after T-die extrusion in the production of a film. The latter method is more preferable in the case where an embossed surface is formed in the present invention.

As the support of the present invention, at least one surface of a multi-layered thermoplastic film composed of at least two layers may be a satin surface or embossed surface composed of the above-described polymer blend. By having such multi-layered structure, properties of each polymer film of respective layers can be combined so that new functions, for example, improvement in the above-described heat sealing property and tear strength while keeping good texture, can be additionally obtained.

In the other specific embodiment of the support of the present invention, for example, at least one surface of a thermoplastic film can be formed to have a satin surface or an embossed surface having a surface roughness (Ra) of about 1/2 or less of the film thickness, while a releasing agent layer can be provided on the other surface. By such construction, effects such as soft touch feeling, high quality feeling in the appearance and improved movability in a line (the decrease in the coefficient of friction) can be exhibited.

In other embodiment of the present invention, at least one surface of a thermoplastic film may be a satin surface or an embossed surface having a surface roughness (Ra) of about 1/2 or less of the film thickness, and a releasing agent layer can he provided thereon.

In this case, the coefficient of static friction of the satin surface or the embossed surface having been subjected to a releasing treatment is less than 1.5, preferably 0.2 to 1.0 and the coefficient of dynamic friction thereof is less than 1.2, preferably 0.1 to 1.0. By making the values fall within these ranges, movability in a line can be improved and effects wherein wrinkles, wandering and cutting hardly occur can be obtained.

The thickness of the above-described support is not particularly limited and usually it is 1 mm or less. However, in view of soft feeling and flexibility, it is desirable that the thickness is 10 to 50 μm, preferably 20 to 40 μm.

While in the present invention, in view of conveyance of the support on the line, the support is required to have a strength to a certain degree. Generally, the support preferably has a tensile strength in the MD direction of 300 gf/10 mm or more, particularly 300 to 1000 gf/10 mm and a tensile strength in the TD direction of 200 gf/10 mm or more, particularly 300 to 1000 gf/10 mm.

When the present invention is used as a base material for a pressure-sensitive adhesive tape, a releasing agent layer is provided on one surface of the support and a pressure-sensitive adhesive layer is provided on the opposite side. A pressure-sensitive adhesive for constituting the pressure-sensitive adhesive layer is not particularly limited. Preferred is a method which comprises transferring a general pressure-sensitive adhesive such as acryl type or rubber type according to a laminate system, and in the case of a direct application, coating is preferably effected according to a curtain blow or melt blow system which does not apply heat.

The present invention will be further described in detail by way of Examples and Comparative Example.

Example 1

On one surface of a low density polyethylene film having a thickness of 30 μm was coated a releasing agent prepared by 100 parts by weight of a cation polymerization type UV curing type silicone releasing agent and 2 parts by weight of an onium salt photoinitiator to provide a thickness of 0.7 μm. Then, UV light was irradiated thereto to form a cured film. Thereafter, the resulting sheet was stretched to obtain a packaging material, base material for pressure-sensitive adhesive tape or separator according to the present invention. As the stretching method (releasing agent layer discontinuing treatment conditions), a stretching machine was used and a stretching treatment was effected at a draw ratio of 1.2 folds in the MD direction and TD direction of the sheet.

Example 2

The packaging material, base material for pressure-sensitive adhesive tape or separator according to the present invention was obtained according to the same manner as in Example 1 except that a releasing agent was prepared by 100 parts by weight of an addition reaction type thermosetting type silicone releasing agent and 2 parts by weight of a platinum curing catalyst and a cured film was formed by using a hot air dryer as the curing condition.

Example 3

The packaging material, base material for pressure-sensitive adhesive tape or separator according to the present invention was obtained according to the same manner as in Example 1 except that as a releasing agent, a radical-polymerization type, acryl-modified, electron ray-curing type silicone releasing agent was used and a cured film was formed by electron ray radiation as the curing condition.

Comparative Example 1

The packaging material, base material for pressure-sensitive adhesive tape or separator according to the present invention was obtained according to the same manner as in Example 1 except that a releasing agent was prepared by 100 parts by weight of a cation polymerization type UV curing type silicone releasing agent and 0.5 part by weight of an onium salt photoinitiator.

In the sample produced under such conditions, a releasing agent layer was not discontinued by a stretching treatment, so that a support layer could not be exposed.

Comparative Example 2

The packaging material, base material for pressure-sensitive adhesive tape or separator according to the present invention was obtained according to the same manner as in Example 1 except that a releasing agent was prepared by 100 parts by weight of a radical polymerization type UV curing type silicone releasing agent and 2 parts by weight of a photocleavage type initiator.

In the sample produced under such conditions, a releasing agent layer was not discontinued by a stretching treatment, so that a support layer could not be exposed.

The breaking strength and the Young's modulus of the used silicone releasing agent film as well as the sealing property evaluation result of the obtained sample are shown in Table 1.

Formation of Releasing Agent Film

The respective releasing agents used in the Examples and Comparative Examples were coated on each polyester film wherein the surface had been subjected to a releasing treatment (PET separator) by means of an applicator. Then, depending upon a kind of a releasing agent, the following curing treatment was effected to form a releasing agent film having a thickness of 150 $\mu$m.

• **Curing condition of a cation polymerization type UV curing type silicone releasing agent;**

Ultraviolet lamp: manufactured by FUSION K.K., F-450 (H-valve)
Ultraviolet light amount: 120 W/cm
Line speed: 5 m/min.
Ultraviolet radiation atmosphere: in air

• **Curing condition of a radical polymerization type UV Curing type silicone releasing agent;**

Ultraviolet lamp: manufactured by FUSION K.K., F-450 (H-valve)
Ultraviolet light amount: 120 W/cm
Line speed: 5 m/min.
Ultraviolet radiation atmosphere: oxygen concentration is controlled to 50 ppm or less by nitrogen substitution

• **Curing condition of an electron ray-curing type silicone releasing agent;**

Electron ray radiation apparatus: manufactured by ESI K.K.. CB-150 ELECTROCURTAIN
Electron ray amount: 3 Mrad
Line speed: 5 m/min.
Electron ray radiation atmosphere: oxygen concentration is controlled to 50 ppm or less by nitrogen substitution

• **Curing condition of thermosetting type silicone releasing agent;**

Curing treatment was effected at a setting temperature of 110°C for 3 minutes by using a hot-air oven.

Measurement condition of breaking strength and Young's modulus of releasing agent film

The releasing agent film prepared according to the above-described conditions was cut at the width of 15 mm, then the measurement was effected by means of a tensile tester under the conditions of a chuck distance of 30 mm and a tensile rate of 30 mm/min.

Releasing Force-Increasing Property

On the releasing agent surface of a sample having a releasing agent layer having been subjected to a discontinuing treatment stretched sample, a pressure-sensitive adhesive tape having a width of 50 mm (trade name: No. 500, manufactured by Nitto Denko Corporation) was adhered at room temperature by reciprocating 2 kg roller once. After 30 minutes, releasing force was measured by means of a tensile tester at a tensile rate of 300 mm/min. and a peel angle of 180°. Then, the ratio (releasing force-increasing property) of this releasing force and that of the sample before stretching (before discontinuing treatment of the releasing agent layer) measured in the same manner as in the above was determined according to the following equation:

Releasing force-increasing property (fold) = releasing force of
a sample after stretching / releasing force of a sample before stretching

Sealing Strength, Adhesion

Surfaces of releasing agent layers of two sheets of sample pieces (width 25 mm) in which the releasing agent layers had been subjected to a discontinuing treatment were put together and one end thereof was adhered with each other at a seal width of 5 mm according to the following two kinds of sealing methods to make a sample for the measurement of sealing strength (refer to Fig. 5). Sealing strength was measured in accordance with T type peeling test at a tensile rate of 300 mm/min. by using a tensile tester.

While the sealed part of a sample for the measurement of sealing strength prepared according to the same method as described above was peeled off with hands and adhesion was evaluated. The evaluation was effected according to the following five criteria.

A: extremely strong
B: strong
C: moderate
D: weak
E: very weak

Sealing Method

1. Heat seal method

Surfaces facing each other of releasing agent layers of samples were heat-sealed by means of a heat-seal machine at 130°C for 2 seconds.

2. Press seal method

Surfaces facing each other of releasing agent layers of samples were sealed by means of a press seal machine with a meshing roll having a press seal pressure of 10 kg/cm$^2$.

Table 1

| | Releasing Agent Film Strength (kg/cm$^2$) | | Releasing Force- Increasing Property | | Heat Seal | | Press Seal | |
|---|---|---|---|---|---|---|---|---|
| | Breaking Strength | Young's modulus | MD | TD | Sealing Strength | Adhesion | Sealing Strength | Adhesion |
| Example 1 | 6 | 3 | 1.2 | 1.2 | 10 | B | 5 | C |
| Example 2 | 8 | 6 | 1.4 | 1.5 | 30 | A | 10 | B |
| Example 3 | 16 | 241 | 1.5 | 1.6 | 40 | A | 25 | B |
| Comparative Example 1 | 1 | 0.1 | 1 | 1 | 0 | E | 0 | E |
| Comparative Example 2 | 2 | 2 | 1.05 | 1.06 | 1 | D | 0 | E |

\* The unit of the sealing strength is g/25 mm.

**Industrial Application Possibility**

The packaging material, base material for pressure-sensitive adhesive tape or separator of the present invention has the above-described construction. Therefore, even if the part to be sealed is composed of surfaces having releasing agent layers, adhesion can be effected according to heat seal or press seal. Further, after being subjected to a discontinuing treatment, the releasing agent layer surface still can maintain releasing property to a pressure-sensitive adhesive article.

As a result, for example, in the case where the present invention is used as a packaging material to be used for directly packaging an article having a pressure-sensitive adhesive part like a sanitary napkin having a pressure-sensitive adhesive layer provided thereon, automation of packaging process using the packaging material having releasing function can be facilitated, because the material enables seal processing of releasing agent layer surfaces facing each other, which has been impossible in a packaging material having a conventional releasing function.

**Claims**

1. A packaging material, base material for pressure-sensitive adhesive tape or separator comprising a releasing agent layer on at least one surface of a film support, wherein said releasing agent layer is composed of a releasing agent film capable of being discontinued such that a part of the support can be exposed.

2. A packaging material, base material for pressure-sensitive adhesive tape or separator comprising a releasing agent layer on at least one surface of a film support, wherein said releasing agent layer has cracks, through which the surface of the film support is exposed.

3. A packaging material, base material for pressure-sensitive adhesive tape or separator as claimed in claim 1 or 2, wherein the releasing agent film constituting the releasing agent layer has a breaking strength of 3.0 kg/cm$^2$ to 30 kg/cm$^2$ and/or a Young's modulus of 2.2 kg/cm$^2$ to 500 kg/cm$^2$.

4. A packaging material, base material for pressure-sensitive adhesive tape or separator as claimed in claim 2, wherein the releasing force increases 1.1 time or more after discontinuing treatment of the releasing agent layer.

5. A packaging material, base material for pressure-sensitive adhesive tape or separator as claimed in claim 2, wherein the sealing strength between the surfaces of the respective releasing agent layers after discontinuing treatment is 2 g/25 mm or more and the upper limit of the sealing strength is not more than the breaking strength of the support.

6. A packaging material having a releasing function as described in anyone of claims 1 to 5, wherein the packaging material is used as a package for a sanitary napkin.

7. A structure of a sealing part of the packaging material, base material for pressure-sensitive adhesive tape or separator as claimed in claim 2, wherein the structure is formed by heat seal processing of surfaces facing each other of the releasing agent layers having cracks.

# FIG. 1

# FIG. 2

# FIG. 3

FIG. 4

FIG. 5

| INTERNATIONAL SEARCH REPORT | International application No. |
|---|---|
| | PCT/JP96/02329 |

**A. CLASSIFICATION OF SUBJECT MATTER**

Int. Cl$^6$   B32B7/06, B32B27/00, C09J7/02

According to International Patent Classification (IPC) or to both national classification and IPC

**B. FIELDS SEARCHED**

Minimum documentation searched (classification system followed by classification symbols)

Int. Cl$^6$   B32B7/06, B32B27/00, C09J7/02

Documentation searched other than minimum documentation to the extent that such documents are included in the fields searched

Jitsuyo Shinan Koho         1926 - 1996
Kokai Jitsuyo Shinan Koho   1971 - 1996

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP, 3-184543, A (Dainippon Printing Co., Ltd.), August 12, 1991 (12. 08. 91), Claim 2; Fig. 2 (Family: none) | 1 - 7 |
| A | JP, 6-503587, A (Minnesota Mining & Mfg. Co.), April 21, 1994 (21. 04. 94), Claim & WO, 9007560, A1 & EP, 452368, B1 | 1 - 7 |

☐ Further documents are listed in the continuation of Box C.          ☐ See patent family annex.

| | |
|---|---|
| *   Special categories of cited documents: | "T"  later document published after the international filing date or priority date and not in conflict with the application but cited to understand the principle or theory underlying the invention |
| "A"  document defining the general state of the art which is not considered to be of particular relevance | |
| "E"  earlier document but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
|---|---|
| September 9, 1996 (09. 09. 96) | September 17, 1996 (17. 09. 96) |

| Name and mailing address of the ISA/ | Authorized officer |
|---|---|
| Japanese Patent Office | |
| Facsimile No. | Telephone No. |

Form PCT/ISA/210 (second sheet) (July 1992)